# EUROPEAN PATENT SPECIFICATION

(11) **EP 0 545 487 B1**
(45) Date of publication and mention of the grant of the patent: **06.08.1997**
(21) Application number: 92203676.9
(22) Date of filing: 27.11.1992
(51) Int. Cl.: H01L 23/495, H01L 21/56

(54) **Semiconductor device encapsulated in resin**
Harzverkapselte Halbleiteranordnung
Dispositif semi-conducteur encapsulé en résine

(30) Priority: 05.12.1991 IT MI913266
(43) Date of publication of application: 09.06.1993
(73) Proprietor: CONSORZIO PER LA RICERCA SULLA MICROELETTRONICA NEL MEZZOGIORNO, 95121 Catania (IT)
(72) Inventor: Mangiagli, Marcantonio, I-95024 Acireale CT (IT); Pogliese, Rosario, I-95030 Gravina Di Catania CT (IT)
(74) Representative: Arena, Giovanni

(56) References cited:
- PATENT ABSTRACTS OF JAPAN vol. 011, no. 059 (E-482) 24 February 1987 & JP-A-61 219 144 (SANKEN ELECTRIC CO LTD) 29 September 1986
- PATENT ABSTRACTS OF JAPAN vol. 014, no. 117 (E-0898) 5 March 1990 & JP-A-01 315 147 (SANKEN ELECTRIC CO LTD) 20 December 1989
- PATENT ABSTRACTS OF JAPAN vol. 010, no. 283 (E-440) 26 September 1986 & JP-A-61 102 040 (SANKEN ELECTRIC CO LTD) 20 May 1986
- PATENT ABSTRACTS OF JAPAN vol. 013, no. 240 (E-767) 6 June 1989 & JP-A-01 042 844 (FUJI ELECTRIC CO LTD) 15 February 1989
- PATENT ABSTRACTS OF JAPAN vol. 011, no. 390 (E-567) 19 December 1987 & JP-A-62 154 656 (TOSHIBA CORP.) 9 July 1987
- PATENT ABSTRACTS OF JAPAN vol. 015, no. 200 (E-1070) 22 May 1991 & JP-A-03 053 551 (NEC CORP.) 7 March 1991
- PATENT ABSTRACTS OF JAPAN vol. 010, no. 221 (E-424) 2 August 1986 & JP-A-61 056 420 (SANKEN ELECTRIC CO LTD) 22 March 1986

## Description

The present invention relates to a semiconductor device encapsulated in resin and electrically insulated having improved insulation characteristics.

A problem encountered in the manufacture of semiconductor devices encapsulated in resin and electrically insulated is ensuring a satisfactory level of quality and reliability of the electrical insulation provided by the package with reference to the following drawbacks.
- high pressure with which the resin is injected in the die during the transfer moulding process,
- the possibility of detachment or resin breakage under the metal plate which, inside the package, supports the semiconductor chip,
- considerable risk of defects in the resin in the region of the pins which ensure plate positioning in the die during the transfer moulding process, and
- the possibility of poor horizontal positioning of the metal plate in the die during the transfer moulding process.

The documents Japanese Patent Abstracts vol.11 (059), (E-482) and JP-A-61219144 describe a method of manufacturing a resin sealed type semiconductor device wherein a specific shaped recess is provided in a resin sealing mold to prevent that air remains in resin and to improve the quality of the device obtained.

The documents Japanese Patent Abstracts vol.13 (240), (E-767) and JP-A-1042844 describe a lead frame for semiconductor device wherein a hole or a notch for resin shifting is made in a bonding part and radiating sheet in order not to leave any air in resin.

The principal purpose of the present invention is to provide an electrically insulated plastic device completely incorporated in resin which in comparison with the known art would be obtainable by less critical manufacturing processes.

Another purpose is to provide a plastic device free of the above mentioned defects and with a higher level of reliability than the known art without increasing manufacturing costs.

The semiconductor device in accordance with the present invention is described in the claim 1 set forth below.

To clarify the innovative principles of the present invention and its advantages as compared with the known art there are described below with the aid of the annexed drawings possible embodiments as nonlimiting examples.

In the drawings:
- FIG.1: shows an axonometric view not in scale of an electrically insulated device in accordance with the know art.
- FIGS.2a-2c: show schematically some phases of a known encapsulation process,
- FIGS.3a-3b: show a top and a cross section view not in scale of the device of FIG. 1.
- FIGS.4a-4e: show a top and various cross section viewS not in scale of a device in accordance with the present invention.
- FIGS.5a-5b: show a top view and side view of the flow lines of the resin inside the cavity of the die during the encapsulation of a device in accordance with the present invention and of a device in accordance with the know art respectively.
- FIGS.6a-6f: show cross sections of some encapsulation process phases for the metal plate positioning system of a device in accordance with the present invention.
- FIGS.7a-7b: show a top view of the metal plate in accordance with the present invention before and after centring.

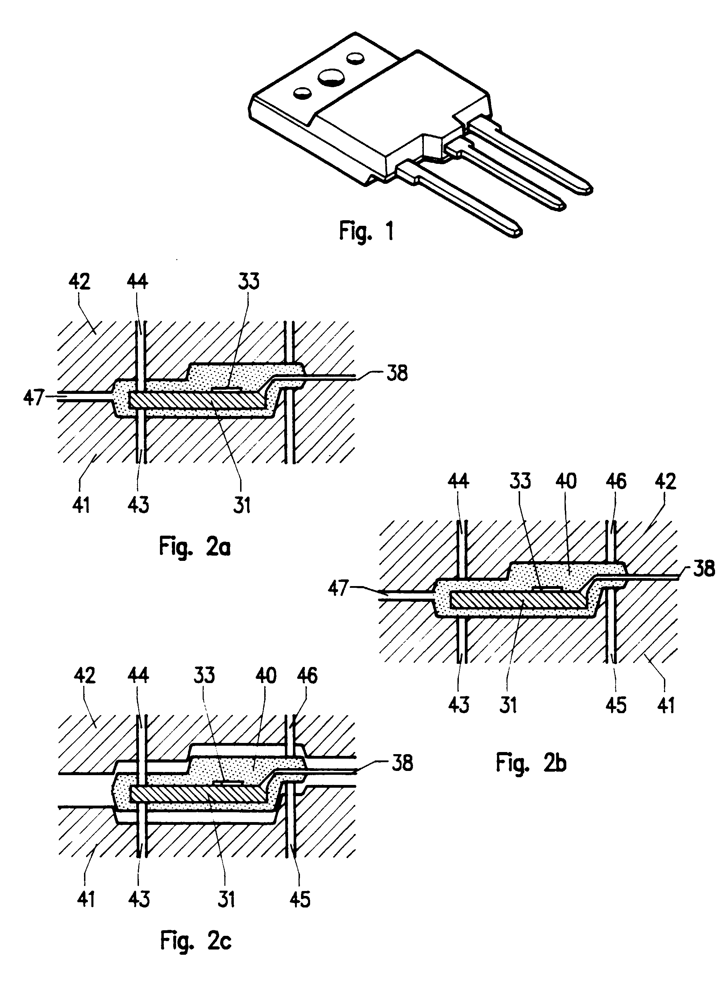

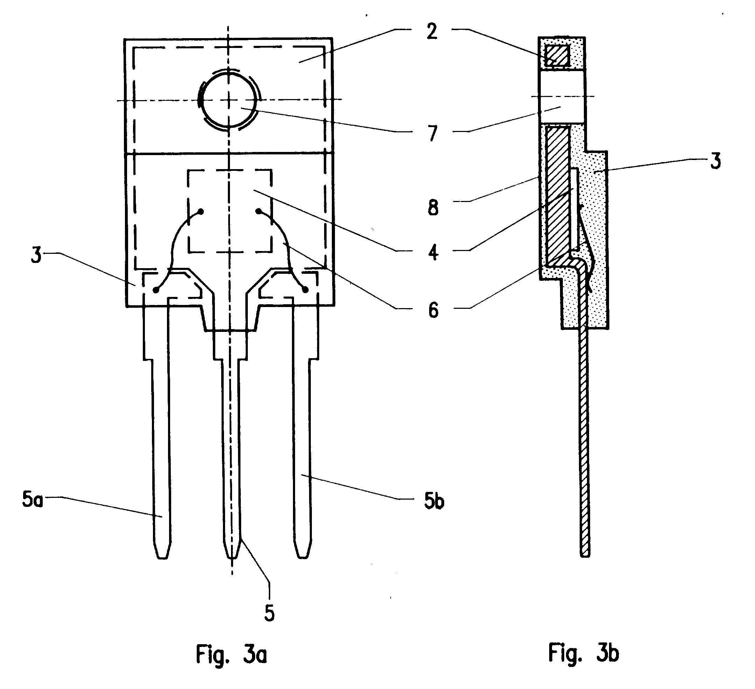

FIGS.1, 2a-2c and 3a-3b represent an example of a known encapsulation process and the device obtained therewith and of which the description can be found in U.S. patent no. 4,888,307. Said device (see FIGS. 1 and 3) comprises a metal plate 2 incorporated in a resin enclosure 3. A semiconductor chip 4 is fixed to the metal plate 2, e.g. by welding alloy. Metal terminals 5a, 5b are incorporated partly in the resin body 3 and are electrically connected to the plate 4 by wires 6.

Another central terminal 5 constitutes the plate extension and acts as the transistor collector. A passing hole 7 both in the metal plate and in the resin body allows fixing the device on a suitable external support or heat sink. Electrical insulation of the device is provided by the same resin 3 which completely incorporates the metal plate 2, covering its lower surface with a thin insulating layer 8.

The device is encapsulated by a process of transfer moulding of an epoxy resin in a suitable die. FIGS. 2a-2c illustrate some phases of a known process (in the figures the metal plate of the device, the central terminal and the semiconductor chip are indicated by 31, 38 and 33 respectively). Said phases call for positioning the plate in the cavity of a die 41/42, correct vertical positioning of the plate by means of retractable pins 43, 44 and inlet of resin through the duct 47 (FIG. 2a). Once the resin has filled the die cavity the pins 43, 44 are retracted and inlet of resin is continued to fill the cavities left by the pins (FIG. 2b). At the end the package obtained is extracted from the die by operating the positioning pins 43, 44 and knockout pins 45, 46.

The problems, difficulties and shortcomings of said package and known processes can be explained by the following considerations.

### 1. High pressure with which the resin is injected during the transfer moulding process.

Insulation obtained with said moulding resin imposes a low defect level in the resin in the package body and in particular in the thin resin layer under the metal plate which must withstand the high insulation tensions. This requirement together with the high hydrodynamic resistance encountered by the resin during input into the die cavity makes it necessary to set high resin injection pressure in the moulding process.

If on one hand the use of high pressures solves the above mentioned problems, on the other hand they cause:
- harmful die cavity wall erosion with resulting significant lowering of die life,
- anomalous connecting movements wires between the semiconductor chip and the external connectors (the flow of resin under high pressure during cavity filling when striking the wires can move them from their proper position and, if the wires are of small diameter, their movement can cause short circuiting or even wire breakage).

### 2. Considerable risk of defects in the resin in the positioning pin regions.

The encapsulation process requires that, after the first phase of filling the die cavity with epoxy resin and after withdrawal of the pins 43, 44, to fill the cavities left by the pins the input of resin must continue under conditions of higher viscosity. This avoids causing anomalous plate movement but, because of said higher resin viscosity, there is poor compacting of said resin (reduced thickness, porosity, etc.) and resulting poor electrical insulation opposite the retractable position pins.

### 3. The possibility of resin detachment or breakage under the plate.

Poor adhesion of the thin layer of resin in contact with the metal plate can cause loss of package flatness in the heat sink zone (one resin layer 8 under the metal plate of the package shown in FIG.3b) or even fracturing of the layer 8 of resin.

Indeed, the different thermal expansion coefficient of the metal plate and resin in the thermal cycles undergone by the device during its life shear stresses the metal-resin junction. If adhesion is insufficient there is loss of contact and in addition if the shear stress is excessive even breakage of the weakest layer of material (resin).

Both phenomena should be avoided because the loss of flatness involves poor heat dispersal and fracturing results in loss of electrical insulation.

### 4. The possibility of poor horizontal metal plate positioning in the die.

Metal plate positioning in the die cavity in accordance with the known art ensures only uniform thickness of the layer 8 of insulation resin (layer involved also in heat dispersion).

The plate terminal part opposite the one to which leads the central connector is of critical positioning in relation to the die cavity side walls. The proper plate position is ensured only in the die part which blocks the central plate connector by adequate locators but this does not ensure centring of the terminal part of the plate (FIG. 3a of the known device showing the plate perfectly centred in relation to the side walls of the resin enclosure is for an ideal case, considering the aforesaid critical plate positioning in the die).

Because of this critical centring during the transfer moulding process the plate can be irregularly spaced from the die side walls or even touch them so as to cause loss of electrical insulation in a side wall of the package thus obtained.

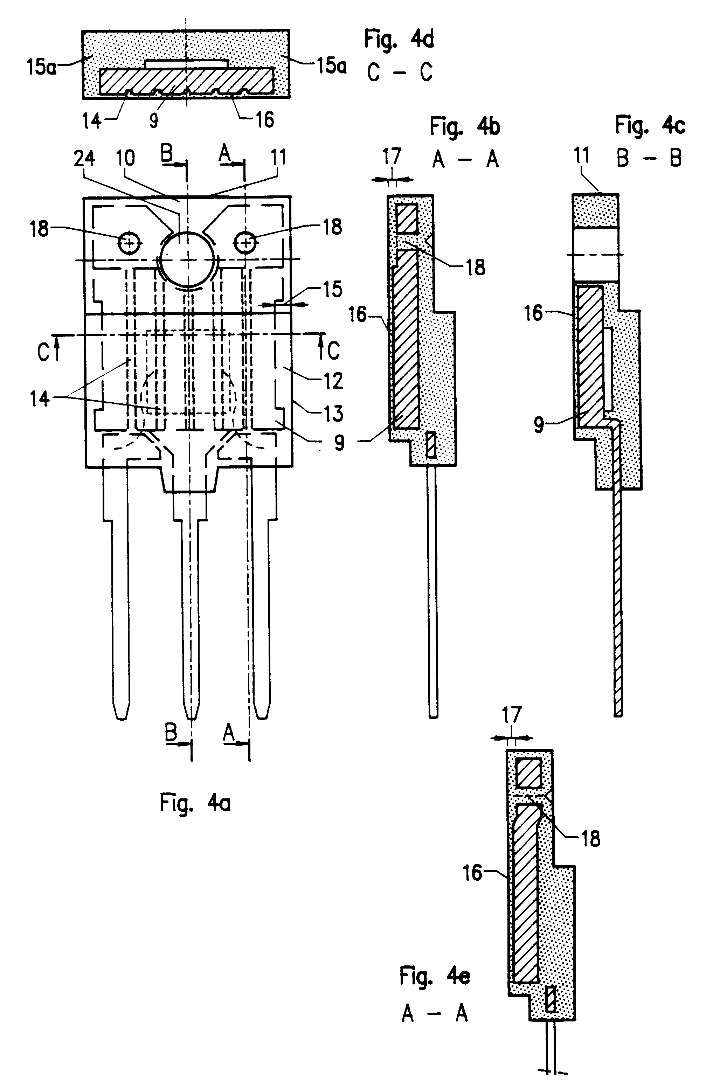

FIGS.4a-4e illustrate the structure of a device in accordance with the present invention. It is characterized by the structure of the known device principally by the following characteristics:
- the hole 24 in the metal plate is open opposite the input slot of the resin in the die cavity (the position of this slot is indicated by 11 in FIG. 4a).
- two recesses 12 are present laterally in the plate opposite the part where the semiconductor chip is welded,
- the plate surface opposite that of support of the semiconductor device displays, on the part opposite that to which leads the central connector, a stepped lowering; as shown in FIGS. 4b and 4e respectively said stepped lowering can be obtained either by removal of material (by milling) or by bending the plate;
- on the plate back and precisely in the zone covered by the thin layer 16 of resin are present straight grooves 14 parallel with the two plate sides in which are present the recesses 12.

The above characteristics take on importance in the light of the following considerations.

### a) Opening 10 in the metal plate:

This opening drastically lowers the hydrodynamic resistance of the resin during its input into the die cavity; thus the resin can flow freely without meeting obstacles.

### b) Lateral plate recesses 12:

These recesses increase the distance 15 between the plate 9 and the walls of the die 13 (said distance goes substantially from 1.0 mm to 2.0 mm) and allows an increase in the flow of resin into the thin insulation layer 16; in this manner the insulation layer 16 is formed of resin coming from two directions: one parallel to that of resin input in the die cavity and the other orthogonal thereto through the lateral recesses 12 present in the plate; the opening 10 and the recesses 12 allow better die filling with low pressures; in addition, once the resin has solidified, these lateral shapes 12 strengthen the zones of lateral hooking 15a of the resin with the plate; said couplings serve to minimize the stresses which the resin induces in the semiconductor chip and in particular during its solidification.

### c) Greater thickness 17 of the resin opposite the positioning pin zone:

The substantial doubling of the thickness of the resin covering the plate back in the zone placed opposite the retractable positioning pins during the transfer moulding process reduces by half in this zone the electrical field of the known art when the device is under voltage; in addition filling of the empty spaces left by the pins after their withdrawal is greatly facilitated (the resin runs on a double thickness); these two phenomena eliminate the defects of the insulation layer under the plate (opposite the pins, made clear in the known art).

### d) Longitudinal channels 14 on the back of the metal plate:

These channels fill a dual function, i.e. they facilitate running of the resin making less critical the phase of creation of the layer 16 and they improve adhesion between the resin layer 16 and the metal plate 9. By creating preferential channels for resin running the insulation layer is formed with greater ease while avoiding the creation of defects (porousness of the resin, nonuniformity of the layer, etc.) which cause electrical insulation alterations. In addition, these channels increase the contact surface and act as hooking zones between the resin layer 16 and the plate 9 to improve adhesion between these two materials. This eliminates the possibility of detachment of the resin from the metal plate and even subsequent fracturing of the insulation layer 16.

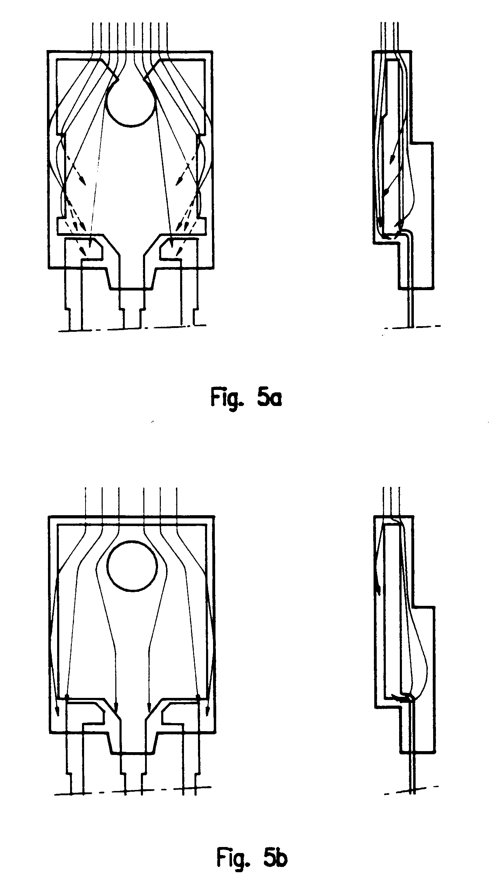

Showing even more clearly the characteristics discussed, FIGS.5a-5b show top and side views of the flow lines of the resin in the die cavity during the encapsulation process of a device in accordance with the present invention and the known art. Said figures confirm the utility of the inventive solutions described above in improving filling dynamics because they provide increase in the flow entering the die cavity and facilitated filling of the die cavity on the side under the plate.

This allows the pressure of the resin during the transfer moulding process to be set lower.

In this manner there is not only benefit for die life but all those problems connected with use of high transfer moulding pressures disappear.

The presence in the metal plate of the two holes 18 adjacent to the hole 24 (FIGS. 4a, 4b, 4e) and filling with resin of the enclosure is important not for correct vertical positioning of the chip in the die (as for example in a known solution described in U.S. patent no. 4,888,307) but for correct horizontal positioning of the plate in the die cavity during the encapsulation process in accordance with the present invention.

FIGS.6a-6f illustrate some phases of an encapsulation process designed to ensure correct horizontal positioning of the metal plate inside the die cavity.

Said figures show the die cavity section along a plane passing through the axes of the two pins nearest the package fixing hole (not shown for the sake of simplicity).

The positioning pins 20 display on the ends which make contact with the plate 9 during its positioning in the die a tapered point 19 which at its base has a diameter smaller than that of the pins.

In the example shown the tapered point forms an angle of approximately 70° and is present only on the die top pins.

In the plate are provided two passing holes 18 having diameter equal to that of the base of the tapered point of the pins.

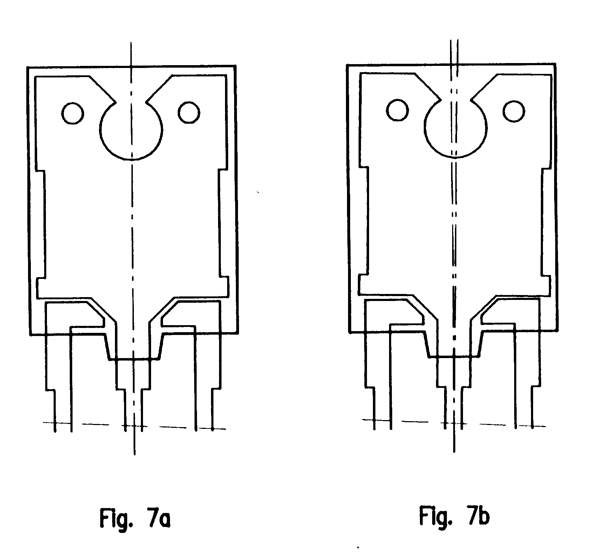

Before resin injection in the moulding die, if the metal plate is not centred horizontally in relation to the die side walls as shown in FIGS.6a and 7a, the centring system thus conceived will position the plate correctly in the cavity (FIGS.6c and 7b), holding said position correctly during the entire moulding process.

FIG.6a represents the moment when the plate 9 is placed in the cavity 22 of the encapsulation die with its terminal part, which bears the fixing hole (for the sake of simplicity not shown in the figures) in an off centre position.

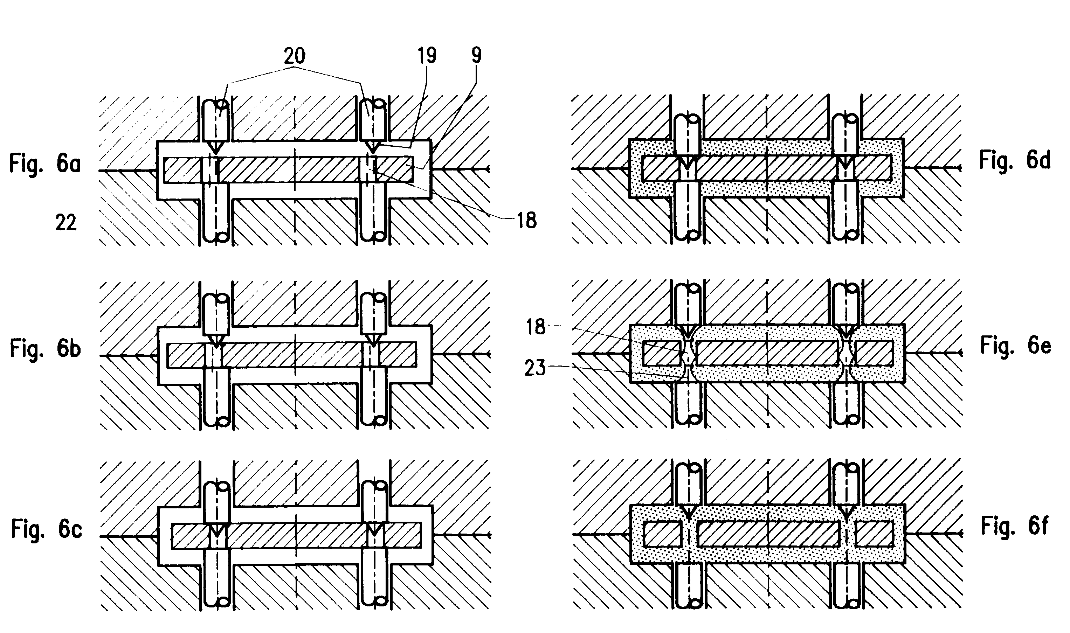

FIG. 6b shows the pins in the positioning phase of the plate. The tapered point 19 of the pins acts on the hole 18, moving the decentralized plate inside the die cavity and then centring it perfectly.

FIG. 6c shows the system with the plate correctly positioned at the beginning of filling.

The diameter of the base of the tapered point less than the diameter of the pins creates an annular surface on which rests the horizontal centring plate and also prevents vertical movement of the plate.

FIG. 6d shows the die cavity already filled with resin with the plate correctly centred.

FIG. 6e shows the phase where the pins are withdrawn and the resin continues to flow to fill the cavity 23 left by the pins and the passing holes 18.

FIG. 6f shows the die cavity entirely filled with resin already solidified and then the semiconductor device with the metal plate perfectly centred inside it and ready to be knocked out in accordance with the known art procedure.

It is clear that correct positioning ensured by the above procedure ensures electrical insulation even on the side walls of the package.

It is equally clear that the device with three terminals described can be generalized for other packages completely incorporated in resin and electrically insulated. As another example, the device in accordance with the present invention can have more than three metal terminals as in integrated circuits.

## Claims

1. Semiconductor device incorporated in resin and electrically insulated comprising: a resin enclosure, a substantially rectangular metal plate incorporated in said resin enclosure, a semiconductor chip welded on a first major surface of said metal plate, a terminal partly incorporated within said resin enclosure and constituting an extension from a first side of said metal plate, said plate and said enclosure being provided with a passing hole designed to allow fixing of the device on a special external support, whereby
a second side of the metal plate opposite said first side comprises a recess (10) which in its innermost part reaches said hole (24) in the plate, and
a second major surface of the plate opposite said first major surface displays a step such that the resin covering the second surface of the plate has a greater thickness between the step and the second side of the plate than between the step and the first side of the plate,
characterized in that:
- said metal plate displays on the two remaining sides opposite the part of the plate where the chip is welded, additional recesses (12) extending for at least one third of their length,
- said recess of said second side displays a mouth at said second side that is not smaller than the diameter of said hole (24); and
- the second surface of the plate displays a series of straight grooves (14) lying along a direction going from the second side toward the first side.

2. Semiconductor device in accordance with claim 1 characterized in that the outline of said additional recesses (12) is of rectangular shape.

## Patentansprüche

1. In Harz eingeschlossenes und elektrisch isoliertes Halbleiterbauelement mit einem Harzgehäuse, einer im wesentlichen rechteckigen Metallplatte, die im Harzgehäuse eingeschlossen ist, einem auf einer ersten Hauptoberfläche der Metallplatte angeschweißten Halbleiterchip, einem teilweise innerhalb des Harzgehäuses eingeschlossenen Anschlußstück, das eine Verlängerung von einer ersten Seite der Metallplatte darstellt, wobei die Metallplatte und das Gehäuse mit einem Durchgangsloch versehen sind, das zur Fixierung des Bauelementes auf einem besonderen externen Träger ausgelegt ist, wobei
eine zweite, der genannten ersten Seite gegenüberliegende Seite der Metallplatte eine Ausnehmung (10) aufweist, die mit ihrem innersten Teil an das genannte Loch (24) in der Platte heranreicht, und
eine zweite, der genannten ersten Hauptoberfläche gegenüberliegende zweite Hauptoberfläche eine Stufe hat, derart, daß die Harzschicht auf der Fläche zwischen der Stufe und der zweiten Seite der Platte eine größere Dicke hat als zwischen der Stufe und der ersten Seite der Platte,
dadurch gekennzeichnet, daß
- die Metallplatte auf den beiden übrigen Seiten gegenüber dem Plattenabschnitt, wo der Chip angeschweißt ist, zusätzliche Ausnehmungen (12) aufweist, die sich über mindestens ein Drittel der Länge dieser Seiten erstrecken,
- die an der genannten zweiten Seite befindliche Ausnehmung an dieser zweiten Seite eine Mündung hat, die nicht kleiner ist als der Durchmesser des Loches (24) und
- die zweite Oberfläche der Platte eine Reihe von geradlinigen Nuten (14) hat, die entlang einer Richtung liegen, welche von der zweiten Seite zur ersten Seite geht.

2. Halbleiterbauelement nach Anspruch 1, dadurch gekennzeichnet, daß der Umriß der zusätzlichen Ausnehmungen (12) rechteckförmig ist.

## Revendications

1. Dispositif semiconducteur incorporé dans de la résine et électriquement isolé comprenant: une enceinte de résine, une plaque métallique sensiblement rectangulaire incorporée dans l'enceinte de résine, une puce semiconductrice soudée sur une première surface principale de la plaque métallique, une borne partiellement incorporée dans l'enceinte de résine et constituant une extension d'un premier côté de la plaque métallique, la plaque et l'enceinte étant munies d'un trou de passage prévu pour permettre la fixation du dispositif sur un support externe adapté, dans lequel:
un second côté de la plaque métallique opposé au premier côté comprend un évidement (10) qui, dans sa partie la plus intérieure, atteint le trou (24) dans la plaque, et
une seconde surface principale de la plaque opposée à la première surface principale présente un palier tel que la résine recouvrant la seconde surface de la plaque a une épaisseur plus grande entre le palier et le second côté de la plaque qu'entre le palier et le premier côté de la plaque,
caractérisé en ce que:
la plaque métallique présente sur les deux côtés restants opposés à la partie de la plaque sur laquelle la puce est soudée, des évidements supplémentaires (12) s'étendant sur au moins un tiers de leur longueur;
l'évidement du second côté présente une embouchure au niveau du second côté qui n'est pas inférieure au diamètre du trou (24); et
la seconde surface de la plaque présente une série de rainures droites (14) s'étendant selon une direction qui va du second côté vers le premier côté.

2. Dispositif semiconducteur selon la revendication 1, caractérisé en ce que le contour des évidements supplémentaires (12) est de forme rectangulaire.
